# EUROPEAN PATENT APPLICATION

(11) **EP 1 413 650 A1**
(43) Date of publication of application: **28.04.2004**
(21) Application number: 02720614.3
(22) Date of filing: 26.04.2002
(51) Int. Cl.: C23F 11/00

(54) **METAL SURFACE PROTECTION FILM FORMING AGENT AND APPLICATION THEREOF**

(30) Priority: 27.07.2001 JP 2001227610
(71) Applicant: Ajinomoto Co., Inc., Tokyo 104-8315 (JP)
(72) Inventor: FURUTA, Kiyonori, Kawasaki-shi, Kanagawa 210-0801 (JP); KURAUCHI, Masahiko, Amino Science Laboratories, Kawasaki-shi, Kanagawa 210-0801 (JP); SATO, Hiroyuki, Amino Science Laboratories, Kawasaki-shi, Kanagawa 210-0801 (JP)
(74) Representative: Nicholls, Kathryn Margaret
(86) International application number: PCT/JP2002/004180
(87) International publication number: WO 2003/012169

(57) **Abstract**

A metal surface protective film forming agent that contains a particular α-amino acid such as leucine, phenylalanine and so on and a metal polishing solution using the same are provided. The metal polishing solution can be used as a polishing solution that is used in the chemical mechanical polishing method that is used in the manufacture of a semiconductor circuit, is constituted of various kinds of additives that are safe and less in the environmental load, and can inhibit the dishing of the metal wiring, in particular, copper base metal wiring from occurring and the corrosion during the polishing from occurring. In particular, when such a particular α-amino acid is used, the α-amino acid is absorbed by a metal surface for wiring, in particular, a surface of copper base metal buried in a recess portion of the base material or reacts with the metal, thereby inhibiting the metal from eluting, and thereby forming a protective film on the surface of the metal.

Furthermore, the invention provides a metal surface protective film forming agent, a method of polishing a surface of a base material for the manufacture of a substrate for semiconductor circuits, a method of forming a metal surface protective film, the use of the particular amino acid to the metal surface protective film forming agent, a substrate for semiconductor circuit that uses these, a semiconductor circuit including these and a method of manufacturing these.

## Description

### Technical Field

The present invention relates to a novel metal surface protective film forming agent and a metal polishing solution using the same, and can provide a metal, in particular, copper base metal surface protective film forming agent that is used in microfabrication of a metal of a substrate for circuits necessary in the manufacturing process and so on of a semiconductor device, in particular a semiconductor circuit, does not deteriorate the characteristics such as the polishing speed and so on, and is low in the cost such as the running cost and a metal polishing solution thereof. Furthermore, the present invention also relates to a polishing method of a surface of a base material for use in manufacture of a substrate for semiconductor circuits, a substrate for semiconductor circuits using the same and semiconductor circuits including the same, and a manufacturing method of these. Still furthermore, the present invention also relates to a method of forming a metal surface protective film and use of a particular component to the metal surface protective film forming agent.

### Background Art

In a semiconductor device, in particular in a semiconductor (integrated) circuit, with the higher integration and higher performance, the design rule thereof yearly becomes more and more finer, the focal depth of a pattern forming resist in a device manufacturing process becomes shallower, and the flatness demanded in a pattern formation surface becomes more stringent.

Furthermore, with finer wiring and higher integration, in order to cope with problems such as heat generation due to an increase in wiring resistance and so on, as the wiring material, in place of the conventional aluminum alloys, use of copper base metals is under active investigation. In the case of the copper base metal is used, it is difficult to form wiring according to the so far frequently used dry etching method. Accordingly, the process such as mentioned below (damascene process) is mainly adopted. That is, after an insulating film-like recess portion (wiring groove and hole) is formed, a copper base metal film for wiring is formed according to the sputtering method, or the plating method, subsequently a unnecessary copper base metal film that is formed insulating film-like is removed by means of the chemical mechanical polishing method (CMP method), and thereby a buried wiring is formed.

A polishing solution that is used in the chemical mechanical polishing method generally includes solid abrasive grains and an oxidizing agent. In a general polishing method, with a polishing solution flowing to a polishing surface plate to which a polishing pad is stuck, a predetermined pressure is applied against the base material therefrom the metal film is formed to press down, and the polishing surface plate is rotated. At this time, the abrasive grains in the polishing solution and the projections of the metal film are subjected to the mechanical friction, and thereby the metal film is removed. The recess portion of the metal film, since an oxide film is formed owing to the oxidizing agent and the polishing pad does not come into contact, becomes difficult to be subjected to the mechanical friction. The metal film of the projection is preferentially removed and a surface of base material is planarized before long.

To the polishing solution, in order to improve the polishing speed, as needs arise, a metal chelating agent is added. As the metal chelating agent, metal chelating agents including aminoacetic acid and amidosulfuric acid, α-oxyacid are reported. However, although the polishing speed in the chemical mechanical polishing method (CMP method) is improved owing to the metal chelating agent, since the oxide film in the recess portion is also dissolved, the recess portion is forwarded in the etching, as a result, there is caused a problem in that a phenomenon (dishing) that a center portion of the metal wiring surface is dented occurs.

In order to inhibit the dishing from occurring, a metal elution inhibitor or the like is added. The metal elution inhibitor forms a protective film on the metal film and works so that the oxide film may not be eluted into the polishing solution. With an intention of suppressing the dishing of the copper base metal wiring and the corrosion thereof during the polishing from occurring, there are reports of a polishing solution that contains benzotriazole as a metal elution inhibitor (JP-A Nos. 8-83780 and 2000-336345.). Furthermore, an example where quinaldic acid is used as the metal elution inhibitor is reported (JP-A No. 9-55363.). Still furthermore, a metal polishing solution that includes a metal oxidizing agent, a metal oxide dissolving agent, a protective film forming agent of which solubility in water at 25 degree centigrade is less than 5% by weight, a protective film forming agent of which solubility in water at 25 degree centigrade is 5% by weight or more, and water is reported (JP-A No. 2000-252244.). In the last patent, among protective film forming agents that are used with the same object as the metal elution inhibitor, as a protective film forming agent of which solubility in water at 25 degree centigrade is less than 5% by weight, benzotriazoles are mainly used, furthermore, as a protective film forming agent of which solubility in water at 25 degree centigrade is 5% by weight or more, although many organic acids and amino acids are exemplified, only benzotriazoles are indicated to be used as a main component. However, specific effects thereof and actually compatibly usable components are not confirmed.

### Problems that the Invention is to Solve

As mentioned above, when so far expected benzotriazoles and so on are used as the metal elution inhibitor, since the inhibition effect thereof is very high, there is a problem in that not only the etching speed is lowered but also the polishing speed is lowered. Furthermore, benzotriazole is known to be carcinogenic; accordingly, an alternative is desired.

Accordingly, it is necessary to develop an excellent component that is specifically used as the metal elution inhibitor or the protective film forming agent.

On the other hand, in recent years, treatment of the industrial waste has been socially problematic. Since the polishing solution that is used in the chemical mechanical polishing method is difficult to recycle, it is disposed as the industrial waste. However, since fine polishing abrasive grains are contained in the polishing solution, it cannot be subjected to the sewage disposal as it is; that is, the fine polishing abrasive grains have to be separated from wastewater. Furthermore, in the case of various kinds of additives being added in the polishing solution, the additives should be desirably separated. However, there are no simple and convenient separation techniques at present time.

Under these situations, development of a metal polishing solution that contains components that can efficiently polish without deteriorating the polishing speed and are excellent in the safety as the metal surface protective film forming agent is in demand.

The present invention intends to overcome the problem and to provide a metal polishing solution that is constituted of various kinds of additives that are safe and less in the environmental load and can inhibit the dishing of metal wiring, in particular, copper base metal wiring and the corrosion during polishing from occurring.

### Disclosure of the Invention

The present inventors, after various investigations to overcome the above problems, found that a particular α-amino acid is absorbed by or reacts with a metal surface, in particular, a copper base metal surface for wiring buried in a recess portion of a base material to form a protective film that can inhibit a metal from eluting on a surface of the metal. Furthermore, it is found that in polishing the metal wiring buried in the recess portion on the base material surface by means of the chemical mechanical polishing method, the polishing with the metal polishing solution containing such a particular α-amino acid is effective in inhibiting the dishing of the metal wiring and the corrosion during the polishing; and such metal polishing solution containing a particular α-amino acid, being able to be constituted of various kinds of additives that are safe and less in the environmental load, can be subjected to the sewage disposal. On the basis of these findings, the present invention came to be completed.

That is, the invention is, as a first mode, a metal, in particular, copper base metal surface protective film forming agent that includes α-amino acid represented by the following formula (1). The α-amino acid includes, other than educts, salts thereof, the salts containing inorganic salts such as sodium salt, potassium salt, calcium salts and magnesium salts and organic salts such as ammonium salts and so on. A preferable form is an educt form that does not contain a metal component or a form of organic salt.

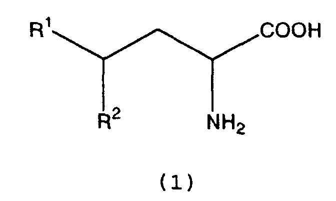

In the above formula (1), R¹ denotes a saturated or unsaturated hydrocarbon group that has from 1 to 20 carbon atoms, preferably from 1 to 10 carbon atoms, and more preferably from 2 to 5 carbon atoms and may have an aromatic ring. For instance, alkyl groups such as a methyl group, ethyl group and propyl group; unsaturated hydrocarbon groups such as a vinyl group and so on; or aralkyl groups such as a phenylmethyl group and phenylethyl group. Furthermore, R² denotes a hydrogen atom or an alkyl group with from 1 to 10 carbon atoms, preferably from 1 to 5 carbon atoms and more preferably from 2 to 5 carbon atoms such as a methyl group, ethyl group and propyl group or an aralkyl group such as a phenylmethyl group and phenylethyl group. R¹ and R² may link to form a ring such as cyclopropyl, cyclobutyl and cyclopentyl, and the ring may be an aromatic ring such as phenyl or naphthyl.

Furthermore, in the α-amino acid, any one of L-isomer, D-isomer and DL-isomer can be used.

Still furthermore, although there are no particular restrictions on the α-amino acid, at least one kind selected from leucine, norleucine, norvaline and phenylalanine is preferably used.

The metal surface protective film forming agent according to the invention need only contain the particular α-amino acid, and auxiliary materials and so on effective in the formation of the metal surface protective film can be used to the extent that does not disturb the object and effect of the metal surface protective film forming agent according to the invention or adversely affect thereon.

As to metals thereto the metal surface protective film forming agent according to the invention is applied, although there are no particular restrictions as far as the metal is one that is used in burying wiring for semiconductor circuit such as aluminum, copper, tungsten and alloys thereof, copper base metals such as copper and alloys thereof are preferable. The "copper base metal" in the invention is a generic name of copper and metals containing copper, and as the copper base metals, copper, alloys of copper and other metals (one or more kinds) and so on can be cited.

The invention can be applied or used in a mode of a metal polishing solution explained below and this mode is also contained in the invention.

The invention, as another mode, is a metal polishing solution that includes the metal surface protective film forming agent, that is a particular α-amino acid that forms a protective film of the metal surface.

As a preferable mode of the metal polishing solution, other than the metal surface protective film forming agent, an oxidizing agent, a metal oxide dissolution agent and water can be contained.

As the oxidizing agent that is used in the invention, there are no particular restrictions as far as it is water-soluble. Peroxides such as hydrogen peroxide, potassium permanganate and so on; nitric acid compounds such as nitric acid and so on; peroxo acid compounds such as peroxo disulfuric acid and so on; oxo acid compounds such as perchloric acid and so on; and ozone (ozone in water and so on) can be cited. These may be used singly or in combinations of two or more kinds. Among these, hydrogen peroxide is particularly preferable because it does not contain metal components and by-products generated by the reaction are harmless. In the case of hydrogen peroxide being used, in order to inhibit a concentration of hydrogen peroxide from varying during storage, hydrogen peroxide water with a predetermined concentration and a solution of other additives (components) (for instance, metal surface protective film forming agent, metal oxide dissolution agent and so on) may be separately prepared and mixed immediately before the use.

A blending amount of an oxidizing agent that is used in the invention, though not particularly restricted, can be preferably used in the range of substantially from 0.01 to 5 moles and more preferably substantially from 0.05 to 3 moles for instance in terms of a content of an effective component of the oxidizing agent with respect to 1 L of the metal polishing solution according to the invention. When the blending amount is less than 0.01 moles, because of insufficient oxidation of the metal, the polishing speed is lowered; on the other hand, in the case of it exceeding 5 moles, there are caused problems in that the smoothness of the surface of metal, in particular copper after polishing deteriorates and so on; accordingly, both cases are not preferable.

As the metal oxide dissolution agents that are used in the invention, organic acids such as, including amino acids such as glycine and alanine, formic acid, acetic acid, propionic acid, butylic acid, n-hexanoic acid, benzoic acid, glycolic acid, salicylic acid, oxalic acid, malonic acid, succinic acid, adipic acid, maleic acid, malic acid and citric acid and their ammonium salts, chelating agents such as ethylenediamine tetracetic acid, glutamic acid diacetate or biodegrading chelating agents and so on can be used. These may be used singly or in combinations of two or more kinds. Among these, in view of the safety and environmental load, amino acids such as glycine, alanine and so on can be preferably used.

A blending amount of the metal oxide dissolution agent that is used in the invention is not particularly restricted but can be preferably used, in terms of a content of, for instance, an effective component of the metal oxide dissolution agent, in the range of substantially from 0.001 to 0.5 moles, and more preferably from 0.005 to 0.3 moles with respect to 1 L of the metal polishing solution according to the invention. When it is less than 0.001 moles, since the metal oxide is insufficiently dissolved, a decrease in the polishing speed results; on the other hand, when it exceeds 0.5 moles, in some cases, the polishing speed may be controlled with difficulty.

Although there is no particular restriction on a blending amount of the metal surface protective film forming agent in the metal polishing solution, it can be determined depending on blending amounts of the oxidizing agent, metal oxide dissolution agent and so on. For instance, it can be preferably used, in terms of a content of the α-amino acid, in the range of substantially from 0.0001 to 5 moles, and more preferably from 0.005 to 1 moles with respect to 1 L of the metal polishing solution according to the invention. When it is less than 0.0001 moles, the protective film is insufficiently formed on the metal surface; on the other hand, when it exceeds 5 moles, in some cases, the polishing speed may be lowered.

The metal polishing solution according to the invention need only contain the particular α-amino acid, and components (oxidizing agent, metal oxide dissolution agent and so on) that can be used in the metal polishing solution and auxiliary materials and so on effective in the formation of the metal surface protective film can be used to the extent that does not disturb or adversely affect on the object and effect of the metal polishing solution according to the invention.

The invention is, as a third mode, a polishing method of a surface of the base material where the surface of the base material that has a recess portion on a surface thereof and is provided with a metal film for wiring in the recess portion is polished by means of the chemical mechanical polishing method with the metal polishing solution according to the invention as a polishing solution, and thereby a metal film formed on the surface is removed.

Furthermore, the invention is, as a fourth mode, a manufacturing method of a semiconductor circuit where in forming metal wiring buried in the recess portion on the surface of the base material by polishing by means of the chemical mechanical polishing method and thereby manufacturing a semiconductor circuit, the metal polishing solution according to the invention is used as a polishing solution.

The invention is, as a fifth mode, a substrate for semiconductor circuits that includes a base material for use in substrate having a recess portion on a surface thereof and a wiring metal disposed in the recess portion wherein a surface of the base material is polished by use of the metal polishing solution according to the invention, and a semiconductor circuit that uses the substrate.

Furthermore, as a still another mode, the invention is a method of forming a metal surface protective film in which α-amino acid represented by the general formula (1) is brought into contact with a metal surface, and the invention is the use of α-amino acid represented by the general formula (1) to the metal surface protective film forming agent.

### Mode for Carrying Out the Invention

In the following, modes for carrying out the invention will be explained.

The present invention includes several modes, that is, a metal surface protective film forming agent, a metal polishing solution thereof, a method of polishing a surface of a base material for manufacturing a substrate for semiconductor circuits, a substrate for semiconductor circuits that uses the above and a semiconductor circuit including the substrate and a method of manufacturing these. Although a metal surface protective film forming agent according to the invention and a metal polishing solution that uses the same will be mainly explained, the invention is not restricted to these.

### (Metal surface protective film forming agent according to the invention)

A metal surface protective film forming agent that is the first mode of the invention will be explained.

A metal surface protective film forming agent according to the invention is a chemical that is used in the manufacture of a semiconductor circuit (substrate) that uses, for instance, the chemical mechanical polishing method, contains a particular α-amino acid represented by the general formula (1), and forms a film that protects a surface of a metal, for instance a metal that is used in the wiring of a substrate in the manufacture of a semiconductor, more preferably a copper base metal (copper, alloys containing copper and so on). The chemical is absorbed by such a metal surface or reacts with a metal to inhibit the metal from eluting, and forms a protective film on the metal surface.

The explanation of the α-amino acid is the same as that mentioned above.

### (Metal polishing solution according to the invention)

A metal polishing solution as a second mode of the invention will be explained.

A metal polishing solution according to the invention is a polishing solution that, in polishing, by means of the chemical mechanical polishing method (CMP method), a surface of a base material that has a recess portion on a surface thereof and is provided with a metal film for wiring in the recess portion to remove the metal film formed on the surface, can form a protective film on a metal surface to inhibit the metal (in particular, copper base metal) from being eluted, and, in order to form the protective film, contains the metal surface protective film forming agent according to the invention. The explanation of the metal surface protective film forming agent is the same as that given above. Accordingly, the metal polishing solution need only contain the particular α-amino acid, and other containable components are as explained above.

On the other hand, since in the metal polishing solution according to the invention, a polishing pad and projections of the metal film are polished owing to the mechanical friction, without containing abrasive grains, a target effect can be sufficiently obtained. However, as needs arise, the abrasive grains may be used.

As a preferable mode of the metal polishing solution, other than the metal surface protective film forming agent, an oxidizing agent, a metal oxide dissolution agent and water may be contained.

The oxidizing agent and the metal oxide dissolution agent that are used in the invention and blending amounts thereof are as mentioned above.

Although a blending amount of the metal surface protective film forming agent in the metal polishing solution is, as mentioned above, determined depending on blending amounts of the oxidizing agent, metal oxide dissolution agent and so on, it can be preferably used, in terms of a content of the α-amino acid, in the range of substantially from 0.0001 to 5 moles, and more preferably from 0.005 to 1 moles with respect to 1 L of the metal polishing solution according to the invention. When the blending amount is less than 0.0001 moles, the protective film is insufficiently formed on the metal surface; on the other hand, when it exceeds 5 moles, in some cases, the polishing speed may be lowered.

### (Polishing method according to the invention)

The invention is a polishing method according to the chemical mechanical polishing method that is used in the manufacture of a substrate for semiconductor circuits, and as a polishing solution that is used there a metal polishing solution according to the invention is used. When, for instance, a surface of a base material that has a recess portion on a surface thereof and is provided with a metal film for wiring in the recess portion is polished to remove the metal film formed on the surface, the method is preferable as a method of polishing a surface of the base material.

When the polishing method that uses the metal polishing solution according to the invention is applied, there are no particular difficulties. For instance, the so far used chemical mechanical polishing method (CMP method), in more detail, a method where a polishing surface plate is rotated with a base material thereon a metal film is formed pressing against the polishing surface plate thereto a polishing pad is adhered under a predetermined pressure to polish may be followed. At this time, the polishing solution is continuously flowed to use, the metal polishing solution according to the invention need only be used as the polishing solution. Alternatively, the metal polishing solution according to the invention can be used in a polishing method that will be developed in future to polish a surface of a base material and so on.

### (Substrate for semiconductor circuits according to the invention, semiconductor circuits including the same and method of manufacturing these)

From the above explanation, in order to manufacture, in particular, a substrate for semiconductor circuits, a metal surface protective film forming agent according to the invention or a metal polishing solution containing the same can be easily used. As a result, a semiconductor circuit that uses the substrate can be easily manufactured. Accordingly, by use of the explanation thereof, known technologies, or a method that will be developed in future, these inventions can be easily performed. For instance, a substrate for semiconductor circuits that includes a base material for substrate having a recess portion for a buried wiring on a surface, and a metal for wiring disposed in the recess portion, wherein a surface of the metal is provided with a protective film that is formed by treating with the metal surface protective film forming agent according to the invention, and a semiconductor circuit or the like that uses the substrate can be manufactured.

As mentioned above, the present invention is, as another mode, a method of forming a metal surface protective film that includes bringing α-amino acid represented by the general formula (1) into contact with a metal surface, and, as a still another mode, the use of α-amino acid represented by the general formula (1) to the metal surface protective film forming agent.

All of these inventions can be easily carried out on the basis of the explanations of the metal surface protective film forming agent according to the invention and various use modes thereof, embodiments described later, or as needs arise, with reference to the existing technologies.

### Preferred Modes for Carrying Out the Invention

The present invention will be detailed below with embodiments; however, the invention is by no means restricted by the embodiments.

### [Embodiment 1]

After 5 ml of 30% hydrogen peroxide water (special grade chemical manufactured by Wako Pure Chemical Industries, Ltd.) was added to 45 ml of deionized water, 0.1 g of glycine (manufactured by Ajinomoto Co., Ltd.) and 0.6 g of L-leucine (manufactured by Ajinomoto Co., Ltd.) were added and stirred to dissolve, and thereby a metal polishing solution was prepared. A copper plate (15 × 50 × 0.2 mm) was immersed in the polishing solution for 30 minutes. After the copper plate was removed, a concentration of copper ion eluted into the polishing solution was quantitatively analyzed by use of ICP Spectrometer (ICAP-75V manufactured by Nippon Jarrell Ash Co. , Ltd.).

### [Embodiment 2]

After 5 ml of 30% hydrogen peroxide water (special grade chemical manufactured by Wako Pure Chemical Industries, Ltd.) was added to 45 ml of deionized water, 0.1 g of glycine (manufactured by Ajinomoto Co., Ltd.) and 0.6 g of DL-leucine (special grade chemical manufactured by Wako Pure Chemical Industries, Ltd.) were added and stirred to dissolve, and thereby a metal polishing solution was prepared. A copper plate (15 × 50 × 0.2 mm) was immersed in the polishing solution for 30 minutes. After the copper plate was removed, a concentration of copper ion eluted into the polishing solution was quantitatively analyzed similarly to embodiment 1 by use of ICP Spectrometer.

### [Embodiment 3]

After 5 ml of 30% hydrogen peroxide water (special grade chemical manufactured by Wako Pure Chemical Industries, Ltd.) was added to 45 ml of deionized water, 0.1 g of glycine (manufactured by Ajinomoto Co., Ltd.) and 0.6 g of L-norleucine (first class grade chemical manufactured by Tokyo Kasei Co., Ltd.) were added and stirred to dissolve, and thereby a metal polishing solution was prepared. A copper plate (15 × 50 × 0.2 mm) was immersed in the polishing solution for 30 minutes. After the copper plate was removed, a concentration of copper ion eluted into the polishing solution was quantitatively analyzed similarly to the above.

### [Embodiment 4]

After 5 ml of 30% hydrogen peroxide water (special grade chemical manufactured by Wako Pure Chemical Industries, Ltd.) was added to 45 ml of deionized water, 0.1 g of glycine (manufactured by Ajinomoto Co., Ltd.) and 0.6 g of L-phenylalanine (manufactured by Ajinomoto Co., Ltd.) were added and stirred to dissolve, and thereby a metal polishing solution was prepared. A copper plate (15 × 50 × 0.2 mm) was immersed in the polishing solution for 30 minutes. After the copper plate was removed, a concentration of copper ion eluted into the polishing solution was quantitatively analyzed similarly to the above.

### [Embodiment 5]

After 5 ml of 30% hydrogen peroxide water (special grade chemical manufactured by Wako Pure Chemical Industries, Ltd.) was added to 45 ml of deionized water, 0.1 g of glycine (manufactured by Ajinomoto Co., Ltd.) and 0.6 g of DL-norvaline (special grade chemical manufactured by Wako Pure Chemical Industries, Ltd.) were added and stirred to dissolve, and thereby a metal polishing solution was prepared. A copper plate (15 × 50 × 0.2 mm) was immersed in the polishing solution for 30 minutes. After the copper plate was removed, a concentration of copper ion eluted into the polishing solution was quantitatively analyzed similarly to the above.

### [Comparative Embodiment 1]

After 5 ml of 30% hydrogen peroxide water (special grade chemical manufactured by Wako Pure Chemical Industries, Ltd.) was added to 45 ml of deionized water, 0.1 g of glycine (manufactured by Ajinomoto Co., Ltd.) was added and stirred to dissolve, and thereby a metal polishing solution was prepared. A copper plate (15 × 50 × 0.2 mm) was immersed in the polishing solution for 30 minutes. After the copper plate was removed, a concentration of copper ion eluted into the polishing solution was quantitatively analyzed similarly to embodiment 1 by use of ICP Spectrometer.

### [Comparative Embodiment 2]

After 5 ml of 30% hydrogen peroxide water (special grade chemical manufactured by Wako Pure Chemical Industries, Ltd.) was added to 45 ml of deionized water, 0.1 g of glycine (manufactured by Ajinomoto Co., Ltd.) and 0.6 g of benzotriazole (manufactured by Junsei Kagaku Kogyo Co., Ltd.) were added and stirred to dissolve, and thereby a metal polishing solution was prepared. A copper plate (15 × 50 × 0.2 mm) was immersed in the polishing solution for 30 minutes. After the copper plate was removed, a concentration of copper ion eluted into the polishing solution was quantitatively analyzed similarly to the above method.

### [Comparative Embodiment 3]

After 5 ml of 30% hydrogen peroxide water (special grade chemical manufactured by Wako Pure Chemical Industries, Ltd.) was added to 45 ml of deionized water, 0.1 g of glycine (manufactured by Ajinomoto Co., Ltd.) and 0.6 g of L-isoleucine (manufactured by Ajinomoto Co., Ltd.) were added and stirred to dissolve, and thereby a metal polishing solution was prepared. A copper plate (15 × 50 × 0.2 mm) was immersed in the polishing solution for 30 minutes. After the copper plate was removed, a concentration of copper ion eluted into the polishing solution was quantitatively analyzed similarly to the above method.

### (Results of quantitative analysis)

Compositions of metal polishing solutions according to the embodiments 1 through 5 and comparative embodiments 1 through 3 and obtained analysis results of copper ions are shown in Table 1.

**[Table 1]**

| Component | Embodiment 1 | Embodiment 2 | Embodiment 3 | Embodiment 4 | Embodiment 5 | Comparative Embodiment 1 | Comparative Embodiment 2 | Comparative Embodiment 3 |
|---|---|---|---|---|---|---|---|---|
| Hydrogen peroxide water (30%) | 5 ml | 5 ml | 5 ml | 5 ml | 5 ml | 5 ml | 5 ml | 5 ml |
| Deionized water | 45 ml | 45 ml | 45 ml | 45 ml | 45 ml | 45 ml | 45 ml | 45 ml |
| Glycine | 0.1 g | 0.1 g | 0.1 g | 0.1 g | 0.1 g | 0.1 g | 0.1 g | 0.1 g |
| L-leucine | 0.6 g | | | | | | | |
| DL-leucine | | 0.6g | | | | | | |
| L-phenylalanine | | | 0.6 g | | | | | |
| L-norleucine | | | | 0.6 g | | | | |
| DL-norvaline | | | | | 0.6g | | | |
| Benzotriazole | | | | | | | 0.6 g | |
| L-isoleucine | | | | | | | | 0.6 g |
| Elution amount of copper ion (ppm) | 2 | 1 | 3 | <1 | 3 | 53 | <1 | 250 |

As obvious from Table 1, the metal polishing solution containing α-amino acid according to the invention is superior to the existing metal polishing solution in the environmental side and quantitative side and conspicuous in the difference in particular from comparative embodiment 3 (an example of another α-amino acid); accordingly, it is understood that the present inventive product is obviously adequate in inhibiting the copper base metal from eluting. Accordingly, all of α-amino acids contained in the inventive metal polishing solutions according to embodiments 1 through 5 are effective as the metal surface protective film forming agent. Furthermore, the use of the metal surface protective film forming agent according to the invention enables to obtain a metal polishing solution that can inhibit the metal film disposed in the recess portion of the base material from eluting and thereby can inhibit the dishing of the metal wiring and corrosion during the polishing from occurring.

### Advantage of the Invention

According to the metal surface protective film forming agent according to the invention, in the manufacture of the semiconductor substrate, the effective component thereof (particular α-amino acid) is absorbed by or reacts with a metal surface for use in wiring, in particular, a copper base metal surface that is buried in a recess portion of the base material, and thereby can inhibit the metal from eluting and effectively form a protective film on a metal surface. Furthermore, in polishing by means of the chemical mechanical polishing method a surface of a base material that has a recess portion on a surface and is provided with a metal film for use in wiring in the recess portion to remove the metal film formed on the surface, when the metal polishing solution containing the particular α-amino acid according to the invention is used as a polishing solution, the metal, in particular copper base metal that is in the recess portion of the base material during the polishing can be inhibited from eluting and the dishing of the metal wiring and the corrosion during the polishing can be inhibited from occurring. Furthermore, since the metal polishing solution that contains such particular α-amino acid can be constituted of various additives that are safe and less in the environmental load, it can be easily subjected to sewage disposal.

Furthermore, the invention, in addition to providing the metal polishing solution, provide the metal surface protective film forming agent, or a polishing method that uses a metal polishing solution including the above, furthermore a method of forming a metal surface protective film, and still furthermore the use of the particular α-amino acid to the metal surface protective film forming agent. Accordingly, the invention is preferable for the substrate for use in semiconductor circuits, a semiconductor containing the same, and a method of manufacturing these.

From the above, it can be understood that the invention is useful in the field of, in particular, semiconductor circuit manufacture. In particular, it is effective also as the metal polishing solution that, without deteriorating the performances such as the polishing speed and so on, is low in the running cost and so on.

## Claims

1. A metal surface protective film forming agent comprising:
α-amino acid represented by the following general formula (1);
wherein the α-amino acid may be a form of salt. 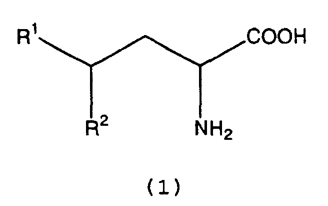 (In the formula, R¹ denotes a saturated or unsaturated hydrocarbon group that has from 1 to 20 carbon atoms and may have at least one aromatic ring, and R² denotes a hydrogen atom or an alkyl group or aralkyl group that has from 1 to 10 carbon atoms. R¹ and R² may link to form a ring.)

2. A metal surface protective film forming agent as set forth in claim 1:
wherein the agent is used for a copper base metal.

3. A metal surface protective film forming agent as set forth in claim 1 or 2:
wherein the α-amino acid is at least one kind selected from leucine, norleucine, norvaline and phenylalanine.

4. A metal polishing solution comprising:
a metal surface protective film forming agent set forth in any one of claims 1 through 3.

5. A metal polishing solution as set forth in claim 4:
wherein the solution comprises an oxidizing agent, a metal oxide dissolution agent and water.

6. A method of polishing a surface of base material comprising:
polishing a surface of base material that has a recess portion on a surface thereof and is provided with a metal film for wiring in the recess portion by means of a chemical mechanical polishing method with a metal polishing solution set forth in claim 4 or 5 as a polishing solution and thereby removing the metal film formed on the surface.

7. A method of manufacturing a semiconductor circuit comprising:
using a metal polishing solution set forth in claim 4 or 5 as a polishing solution when a metal wiring buried in a recess portion of a surface of a base material is formed by polishing by means of a chemical mechanical polishing method to manufacture a semiconductor circuit.

8. A substrate for semiconductor circuit comprising:
a base material for substrate having a recess portion on a surface thereof; and
a wiring metal disposed in the recess portion;
wherein a surface of the base material is polished by use of a metal polishing solution set forth in claim 4 or 5.

9. A semiconductor circuit comprising:
a substrate set forth in claim 8.

10. A method of forming a metal surface protective film comprising:
bringing α-amino acid represented by the following general formula (1) into contact with a metal surface;
wherein the α-amino acid may be a form of salt. 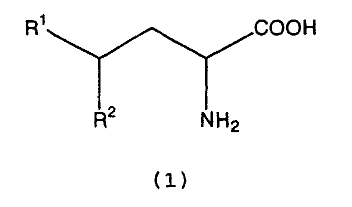 (In the formula, R¹ denotes a saturated or unsaturated hydrocarbon group that has from 1 to 20 carbon atoms and may have at least one aromatic ring, and R² denotes a hydrogen atom or an alkyl group or aralkyl group that has from 1 to 10 carbon atoms. R¹ and R² may link to form a ring.)

11. Use of α-amino acid represented by the following general formula (1) to a metal surface protective film forming agent;
wherein the α-amino acid may be a form of salt. 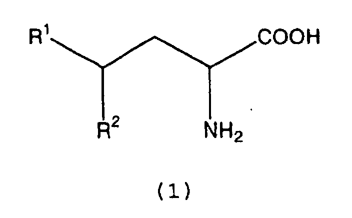 (In the formula, R¹ denotes a saturated or unsaturated hydrocarbon group that has from 1 to 20 carbon atoms and may have at least one aromatic ring, and R² denotes a hydrogen atom or an alkyl group or aralkyl group that has from 1 to 10 carbon atoms. R¹ and R² may link to form a ring.)
